# EUROPEAN PATENT SPECIFICATION

(11) **EP 3 188 577 B1**
(45) Date of publication and mention of the grant of the patent: **30.01.2019**
(21) Application number: 16204537.1
(22) Date of filing: 15.12.2016
(51) Int. Cl.: H05K 3/28, C23F 11/14, C23C 22/52

(54) **METHOD FOR FORMING ORGANIC COATING ON COPPER SURFACE**
VERFAHREN ZUR HERSTELLUNG EINER ORGANISCHEN BESCHICHTUNG AUF EINER KUPFEROBERFLÄCHE
PROCÉDÉ DE FORMATION D'UN REVÊTEMENT ORGANIQUE SUR UNE SURFACE EN CUIVRE

(30) Priority: 29.12.2015 US 201562272135 P
(43) Date of publication of application: 05.07.2017
(73) Proprietor: Rohm and Haas Electronic Materials LLC, Marlborough, MA 01752 (US)
(72) Inventor: TANG, Qin, Fanling, NT (HK); TONG, Kitho, Fanling, NT (HK); CHAN, Chit Yiu, Taiwai, NT (HK); YEE, Kwok Wai Dennis, Yuen Long (HK)
(74) Representative: Houghton, Mark Phillip

(56) References cited:
- US-A1- 2008 163 787
- US-A1- 2014 174 322
- US-B1- 6 524 644

## Description

### Field of the Invention

The present invention relates generally to a method for forming an organic coating on a surface of copper to prevent corrosion of copper. In particular, the present invention relates to a method for forming an organic solderability film on copper surface of an electronic component selectively, in which the electronic component comprises both copper and gold surfaces.

### Background of the Invention

Copper and its alloys are the most commonly used metals in electronic applications such as providing conductive circuit paths for printed boards (PCBs). PCBs require electronic components to be attached to copper or copper alloy surface pads or through-holes by a soldering operation. Leaded components can be inserted into through-holes followed by wave soldering, or surface mount technology (SMT) components can be attached to surface pads by applying solder paste to the surface, for example by screen printing, then placing the component onto paste followed by reflow soldering. For SMT assembly operations a minimum of two reflow cycles are required in order to attach components to both the front and back of the PCB. For more complex assemblies additional reflow operations may be required to attach additional components or to carry out repair operations.

The copper surfaces of PCB pads to which components are mounted are typically coated with a protective metallic or non-metallic finish. Such protective finishes are designed to maintain good solderability by preventing the copper surface from being oxidized either during storage after PCB fabrication or during exposures to soldering temperatures.

Organic solderability preservative (OSP) is used to protect the surface of metals with the excellent surface co-planarity of the coated surface, such as US 6,524,644B, US20070221503A, EP291743B and KR2012017967A. However, most of those references disclose azole compounds such as imidazole or benzimidazole, and the protectiveness of these OSPs is still poor and their solderability performances are always deteriorated after surfaces are placed under multiple high temperature reflow cycles.

US2014174322A discloses a preservative film comprising an azine compound. However, when the technology disclosed in the art is applied to PCBs which have copper and gold surfaces, the OSP film is formed not only on the copper surfaces but also the gold surfaces, and it causes deterioration of conductivity of the gold surfaces. Therefore, a method for preventing oxidization of copper surfaces with good selectivity on copper surfaces is still desired.

US2008/163787 discloses an organic solderability preservative (OSP) composition comprising an alkyl cyclic alcohol and an azole compound having enhanced composition stability against crystallization of the azole compound,

US 6 524 644 B1 discloses a method for treating electronic components such as printed wiring boards (PWB's) containing both copper and gold circuitry to provide an organic solderability preservative (OSP) coating on the copper before the copper is soldered with the gold features on the substrate, which method comprises the pretreatment with a solution comprising benzimidazole and then the treatment with a solution comprising a substituted benzimidazole compound, preferably at the 2-position.

### Summary of the Invention

The present invention provides a method for selectively forming OSP film on copper surfaces of an article to effectively prevent oxidization of the copper surfaces.

Therefore, one aspect of the invention relates to a method for forming an organic film on a copper surface of an article, comprising the steps of: (a) contacting the copper surface with a first solution comprising benzimidazole or derivatives thereof, and (b) contacting the copper surface, after being contacted with the first solution, with a second solution comprising a compound represented by the formula (I) 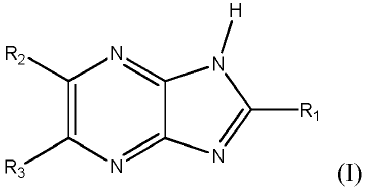 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 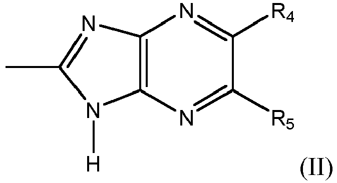 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

In another aspect, the invention relates to an organic film on a copper surface comprising (i) a first layer formed on the copper surface and comprising benzimidazole or derivatives thereof and (ii) a second layer formed on the first layer and comprising a compound represented by the formula (I) 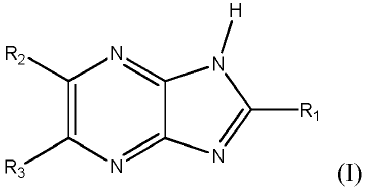 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 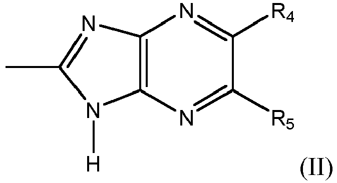 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

In still a further aspect, the invention relates to a method for protecting a copper surface of an article from oxidation, comprising the steps of: (a) preparing an article having a copper surface, (b)contacting the copper surface of the article with a first solution comprising benzimidazole or derivatives thereof to form a first organic film on the surface of copper, (c) contacting the copper surface which has the first organic film with a second solution comprising a compound represented by the formula (I) 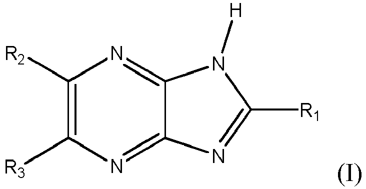 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 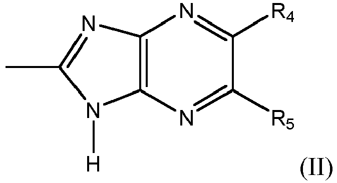 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms, and (d) drying the copper surface to form an organic film on the surface.

### Detailed Description of the Invention

As used throughout this specification, the abbreviations given below have the following meanings, unless the context clearly indicates otherwise: g = gram(s); mg = milligram(s); L = liter(s); mL = milliliter(s); ppm = parts per million; m=meter(s); mm = millimeter(s); cm=centimeter(s); min.= minute(s); s = second(s); hr.= hour(s); °C = degree(s) C = degree(s) Celsius; vol%=volume percent(s) = percent(s) by volume; wt%=weight percent(s) = percent(s) by weight.

The terms "plating" and "deposition" are used interchangeably throughout this specification.

Methods of the present invention are for forming an organic film on a copper surface of an article, comprising the following two steps. The first step is; contacting the copper surface with a first solution comprising benzimidazole or derivatives thereof.

Examples of the benzimidazole or derivatives thereof include benzimidazole, 2-methyl-benzimidazole, 2-ethyl-benzimidazole, 2-propyl-benzimidazole, isopropyl benzimidazole, 2-butyl-benzimidazole, 2-tert-butyl-benzimidazole, 2-pentyl benzimidazole, 2-hexyl-benzimidazo le, 2-(l-methylpentyl)-benzimidazole, 2-heptyl-benzimidazole, 2-(l-ethyl-pentyl)-benzimidazole, 2-octyl-benzimidazole, 2-(2,4,4-trimethyl-pentyl)-benzimidazole, 2-nonyl-benzimidazole, 2- (9-octenyl)-benzimidazole, 2-(8-heptadecenyl)-benzimidazole, 2-(4-chlorobutyl)- benzimidazole, 2-(9-hydroxy-nonyl)-benzimidazole, 2-hexyl-5 -methyl- benzimidazole, 2-heptyl-5,6-dimethyl-benzimidazole, 2-octyl-5-chloro- benzimidazole, 2-ethyl-5-octyl-6-bromo-benzimidazole, 2-pentyl-5,6-dichloro- benzimidazole, 4-fluoro-benzimidazole, 2-hydroxyl-benzimidazole, 2-mercapto-benzimidazole, 2-(4-chlorobenzyl)-1H-benzimidazole, 2-(4-bromobenzyl)-1H-benzimidazole, 2-(4-fluorobenzyl)-1H-benzimidazole.

The benzimidazole or derivatives thereof may be included in the first solution in amounts of 0.01 g/L to 50 g/L, preferably from 0.1 g/L to 20 g/L, more preferably from 0.5 g/L to 10 g/L. Such compounds may be commercially available or they may be made according to process known in the art or disclosed in the literature.

The first solution also includes one or more acids or bases to adjust the pH of the solution to a range of 1.0 to 11.0, preferably from 3.0 to 9.0, more preferably from 5.0 to 8.0. Acids which can be used for the first solution include but are not limited to inorganic acids such as hydrochloric acid, sulfuric acid, nitric acid, phosphoric acid and hydrofluoric acid and organic acids such as acetic acid, citric acid, tartaric acid, ascorbic acid, malic acid, formic acid and salts thereof. Bases which can be used for the first solution include but are not limited to ammonia, ethanolamine, diethanolamine, triethanolamine, triisopropylamine and other alkylamines.

Solubilizers are typically used to dissolve the active coating ingredient in the solution. Optionally, one or more alcohol may be used to solubilize the active ingredient where in the active ingredient is dissolved in the alcohol and then added to the water used to make the first solution. Such solubilizers include, but are not limited to, 1-butanol, 1-pentanol, 2-pentanol, other pentanols, 1-hexanol, other hexanols, heptanols, furfuryl alcohol, terahydrofurfuryl alcohol and alkyl cyclic alcohol.

Optionally one or more complexing or chelating agents can be included in the first solution. Conventional complexing or chelating agents may be used. Such complexing or chelating agents include, but are not limited to; carboxylic acids such as acetic acid, formic acid, nitrilo-triacetic acid, tartaric acid, gluconic acid, phthalic acid, citric acid, ethylenediaminetetraacetic acid (EDTA) and N-(2-hydroxyethyl)ethylenediamine-N,N',N'-triacetic acid trisodium salt (HEDTA); carboxylic acid-substituted N-containing heterocyclic compounds such as picolinic acid, quinolinic acid, nicotinic acid, fusaric acid, isonipecotic acid, pyridine dicarboxylic acid, piparazine carboxylic acid, pyrrole carboxylic acid and pyrolidine; amino carboxylic acids; polyamines; amino alcohols such as ethanolamine and dimethylethanolamine; sulfur containing compounds such as thiols, disulfides, thioethers, thioaldehydes, thioketones, thiourea and its derivatives, thioglycols, mercaptoacetic acid, mercaptopropionic acid and mercaptosuccinic acid; amines such as ethylenediamine and ammonia; and amino acids such as glutamic acid, aspartic acid, lysine, histidine, alanine, glycine, glutamine, valine, cysteine and methionine.

The first solution can further comprise an azine compound as disclosed below. the azine compound may be included in the first solution in amounts of 0.01 g/L to 1 g/L, preferably from 0.05 g/L to 0.5 g/L, more preferably from 0.1 g/L to 0.3 g/L.

The first solution is applied to a copper surface of an article to form a first layer of an organic film on the surface of the copper. Preferably, the article can have both copper surface and gold surface. The organic film deposits selectively on a copper surface rather than a gold surface. Examples of such articles include but not limited to, printed circuit boards, electronic components such as diodes, transistors, integrated circuits components, optoelectronic devices, and decorative accessories.

The first solution may be applied to a copper surface of an article by any suitable process known in the art. Such processes include, but are not limited to, dipping copper surfaces of the article into the solution, spraying the solution onto the copper surfaces of the article or by brushing the solution on the copper surfaces of the article. In general, the solution is applied at temperatures from room temperature to 90 ° C, preferably from 30 ° C to 70 ° C. Contact time between the copper surfaces of the article and the solution prior to the next processing step may range from one minute to ten minutes, preferably from one minute to five minutes. Optionally the copper surfaces of the article may be air dried at room temperature and then the article may be rinsed with water at room temperature followed by cold air drying at temperatures of 10 to 25 °C. The dried first layer of an organic film on the copper surfaces typically is a thin, sometimes un-continuous film. The thickness of the first layer is typically 10 to 200 nm, more typically from 30 to 150 nm.

Prior to applying the first solution to the copper surfaces of the article, the copper surfaces are typically cleaned or etched or cleaned and etched to remove any organic contamination and surface oxidation. The article is optionally rinsed with water and dried, then contacted with the first solution.

The second step of the method is; contacting the copper surface with a second solution comprising a specific pyrazine derived compound. The pyrazine derived compound used in the invention is represented by the formula (I)

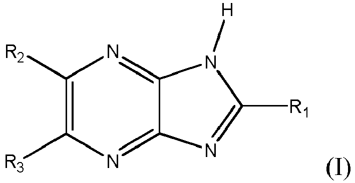

In the formula (I), R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl. R₂ and R₃ may be taken together with all of their atoms to form a five membered heterocyclic ring wherein the heterocyclic ring includes two nitrogen atoms as the hetero-atoms, and R₁ can have the following structure:

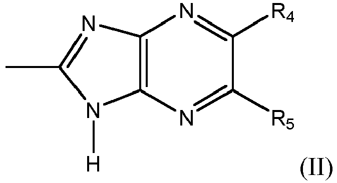

In formula (II), R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl. R₄ and R₅ may be taken together with all of their atoms to form a five membered heterocyclic ring wherein the heterocyclic ring includes two nitrogen atoms as the hetero-atoms.

When R₂ and R₃ are taken together to form a five membered heterocyclic ring, compounds have a structure: 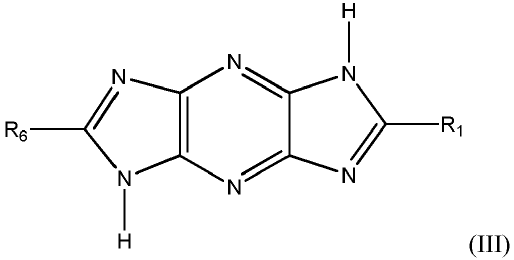 wherein R₁ is defined as above and R₆ is the same as R₁ with the proviso that R₆ is not a structure as formula (II) above.

When R₁ of structure (I) is structure (II) as defined above, the structure is as follows: 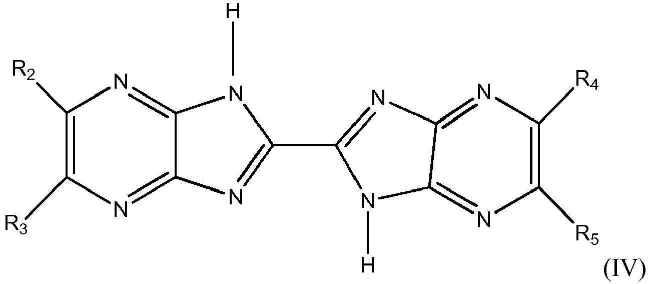 wherein R₂, R₃, R₄ and R₅ are as defined above.

When R₄ and R₅ are taken together to form a five membered heterocyclic ring the structure is as follows: 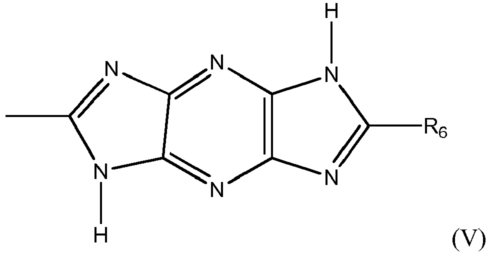 wherein R₆ is as defined above.

Hydrocarbyl typically has from one to twenty-five carbon atoms, preferably from one to twelve carbon atoms, more preferably from one to seven carbon atoms. The hydrocarbyl may be methyl, ethyl, n-propyl, isopropyl, n-butyl, isobutyl, tert-butyl, pentyl, hexyl, heptyl, phenyl or benzyl. Substitutents on substituted hydrocarbyl include, but are not limited to nitro, amino, halide, cyano, carbonyl, carboxyl, hydroxyl and alkoxyl. Halides include fluoride, chloride and bromide, typically the halide is chloride and fluoride, more typically the halide is chloride.

Substituted or unsubstituted, linear or branched alkoxyl and substituted or unsubstituted, linear or branched amino and amide may have from one to twenty-five carbon atoms, preferably from one to twelve carbon atoms and more preferably from one to six carbon atoms. Substituents on the substituted alkoxyl and substituted amino and amide include but are not limited to, nitro, amino, halide, cyano, carbonyl, carboxyl, hydroxyl and alkoxyl.

Substituted or unsubstituted linear or branched carboxyl and carbonyl may have from one to twenty-five carbon atoms, preferably from one to twelve carbon atoms and more preferably from one to six carbon atoms. Substituents include, but are not limited to nitro, halide and hydroxyl.

Substituted or unsubstituted linear or branched ester and thioester may have from two to twenty-five carbon atoms, preferably from two to twelve carbon atoms and more preferably from two to six carbon atoms. Substituents include, but are not limited to, nitro, halide, hydroxyl and cyano.

Substituted or unsubstituted linear or branched alkylthio groups may have from one to twenty-five carbon atoms, preferably from two to twelve carbon atoms and more preferably from two to six carbon atoms. Substituents include, but are not limited to, nitro, halide, hydroxyl and cyano.

Boryl has the following structure: 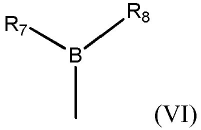 wherein R₇ and R₈ are independently hydrogen, substituted, unsubstituted, linear or branched alkyl groups having from one to ten carbon atoms preferably from one to five carbon atoms, most preferably R₇ and R₈ are hydrogen. Substituents include, but are not limited to, nitro, hydroxyl and halide.

Silyl has the following structure: 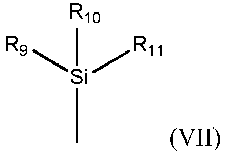 wherein R₉, R₁₀ and R₁₁ are independently hydrogen, or substituted, unsubstituted, linear or branched one to five carbon alkyl; or phenyl. Preferably R₉, R₁₀ and R₁₁ are from one to four carbon alkyl groups or phenyl. Examples of such silyl groups are trimethyl silyl, tert-butyldiphenyl silyl, ter-butyl dimethyl silyl and triisoprpoyl silyl. Substituents include, but are not limited to halide, nitro and hydroxyl.

Preferably R₁, R₂ and R₃ are independently hydrogen, hydroxyl, substituted or unsubstituted, linear or branched alky or alkoxy with one to six carbon atoms. Substituents on the alky and alkoxy include, but are not limited to, hydroxyl, carboxyl, amino and carbonyl. More preferably R₁, R₂ and R₃ are independently hydrogen, hydroxyl, substituted or unsubstituted, linear or branched alkyl with one to five carbon atoms where the substituents include, but are not limited to, hydroxyl and amino. Most preferably, R₁, R₂ and R₃ are independently hydrogen, hydroxyl or hydroxyalkyl having one to five carbon atoms. Even more preferred are when R₁, R₂ and R₃ are hydrogen.

The pyrazine derived compounds having the foregoing structures may be included in the compositions in amounts of 00.1 g/L to 50 g/L, preferably from 0.1 g/L to 20 g/L, more preferably from 1 g/L to 10 g/L. Such compounds may be commercially obtained or they may be made according to processes known in the art or disclosed in the literature.

The solution also includes one or more acids, preferably, organic acids, to adjust the pH of the compositions to a range of 1 to 10, preferably from 1 to 7, more preferably from 2 to 5. Inorganic acids include, but are not limited to hydrochloric acid, sulfuric acid, nitric acid, phosphoric acid and hydrofluoric acid. Organic acids include, but are not limited to, carboxylic acids and their salts. Such carboxylic acids include, but are not limited to, acetic acid, citric acid tartaric acid, ascorbic acid, malic acid, formic acid and salts thereof. In general, inorganic and organic acids are included in the compositions in amounts of 0.1 g/L to 10 g/L; however, the amount may vary since the acids are included in sufficient amounts to maintain the desired pH.

Solubilizers are typically used to dissolve the active coating ingredient in the solution. Optionally, one or more alcohols may be used to solubilize the active ingredient where the active ingredient is dissolved in the alcohol and then added to the water used to make the treating solution. Such solubilizers include, but are not limited to, 1-butanol, 1-pentanol, 2-pentanol, other pentanols, 1-hexanol, other hexanols, heptanols, furfuryl alcohol, tetrahydrofurfuryl alcohol and alkyl cyclic alcohol.

One or more sources of metal ions can be included in the solution. Metal ions are included to increase the rate of film formation, provide for a more uniform film layer and also lower operating temperatures of the solution. Such metal ions include, but are not limited to copper, tin, zinc, silver, nickel, lead, manganese, barium, palladium and iron. Preferably the metal ions are chosen from copper, tin, zinc, silver, manganese, iron and nickel. More preferably the metal ion is copper. Sources of the metal ions may include any water soluble organic or inorganic metal salt such as water soluble metal salts of halides, nitrates, acetates, sulfates, oxides, alkylsulfonates, formates, gluconates, tartrates, oxalates, acetates and lactates. Many of such metal salts are commercially available or may be made based on disclosures in the literature. In general such salts are included in the solution in amounts of 0.001 g/L to 5 g/L, preferably from 0.01 g/L to 3 g/L. Such salts are added in amounts to provide metal ions at concentrations of 1 ppm to 5,000 ppm, preferably from 10 ppm to 3,000 ppm.

Instead of the metal salts disclosed above, ammonium chloride can be added to generate copper ions in the solution. When ammonium chloride is included in the solution, copper surface of an article is mildly etched thus free copper ion is released in the solution. In general, ammonium chloride is included in the solution in amounts of 1 ppm to 2,000 ppm, preferably 2 ppm to 1,000 ppm, more preferably 10 ppm to 500 ppm, the most preferably 20 ppm to 100 ppm.

Optionally one or more complexing or chelating agents can be included in the solution. Conventional complexing or chelating may be used. Such complexing or chelating agents include, but are not limited to, carboxylic acids such as acetic acid, formic acid, nitrilo-triacetic acid, tartaric acid, gluconic acid, phthalic acid, citric acid, ethylenediaminetetraacetic acid (EDTA) and N-(2-hydroxyethyl)ethylenediamine-N,N',N'-triacetic acid trisodium salt (HEDTA); carboxylic acid-substituted N-containing heterocyclic compounds such as picolinic acid, quinolinic acid, nicotinic acid, fusaric acid, isonipecotic acid, pyridine dicarboxylic acid, piparazine carboxylic acid, pyrrole carboxylic acid and pyrolidine; amino carboxylic acids; polyamines; amino alcohols such as ethanolamine and dimethylethanolamine; sulfur containing compounds such as thiols, disulfides, thioethers, thioaldehydes, thioketones, thiourea and its derivatives, thioglycols, mercaptoacetic acid, mercaptopropionic acid and mercaptosuccinic acid; amines such as ethylenediamine and ammonia; and amino acids such as glutamic acid, aspartic acid, lysine, histidine, alanine, glycine, glutamine, valine, cysteine and methionine.

The second solution is applied to the copper surface fully or partially covered by the first organic film. The second solution may be applied to the copper surface of an article by any suitable process known in the art. The same processes disclosed in the first step can be applied, such as dipping, spraying or brushing. In general, the second solution is applied at temperatures from room temperature to 90° C, preferably from 30° C to 70° C. Contact time between the copper surface with the first organic film and the second solution prior to the next processing step may range from one minute to ten minutes, preferably from one minute to five minutes.

After the second step, the copper surface of the article optionally may be air dried at room temperature and then the article may be rinsed with water at room temperature followed by hot air drying at temperatures of 50 to 70° C. The dried film on the copper surface typically forms a uniform layer from 10 nm to 500 nm thick, preferably from 10 nm to 200 nm thick, more preferably from 20 nm to 100 nm thick.

The methods enable the formation of a continuous and substantially uniform organic film on copper surfaces. The film has good anticorrosion properties and thermal stability and retains solderability of copper surfaces even after multiple heat cycles. In addition, the methods provide selective deposition of organic film on copper surfaces with substantially no deposit on gold surfaces. "Substantially no deposit" means the area of organic film deposition on gold surfaces is 10 % or less based on the total area of the gold surfaces. Preferably, the area of organic film deposition on gold surfaces is 5 % or less, more preferably no change in appearance is found on gold surfaces after the process of the invention. Therefore, the methods of the invention are useful for applications in which an article already has other surface finishes such as gold.

### Examples

### Examples 1-4

The following two baths were prepared.

**Table 1 Bath 1**

| Chemicals | Amounts |
|---|---|
| Benzimidazole | 5 g/L |
| 1H-imidazole[4,5-b]pyrazine | 100 ppm |
| Acetic acid | adjust pH |
| Water | remains |

| | |
|---|---|
| pH of the Bath 1 was 6.8 - 6.9. | |

**Table 2 Bath 2**

| Chemicals | Amounts |
|---|---|
| 1H-imidazole[4,5-b]pyrazine | 0.5 g/L |
| Acetic acid /Ammonia | adjust pH |
| Ammonium chloride | 100 ppm |
| Water | remains |

| | |
|---|---|
| pH of the Bath 2 was 3.7 - 4.0. | |

Test panels (FR-4 copper clad laminate from Shenzhen Fastprint Circuit Technology) were treated according to the process disclosed in Tables 3 and 4 below.

**Table 3 Process**

| Step | Process Bath | Conditions |
|---|---|---|
| Cleaner | RONACLEAN™ LP-200 sulfuric acid | 50°C, 5 min |
| Water Rinse | - | 25°C, 1 min |
| Micro-etch | 100 g/l Sodium Persulfate 20 ml/l sulfuric acid | 25°C, 2 min |
| RO Rising | - | 25°C, 2 min |
| Pre-dip | 5% sulfuric acid | RT, 1min |
| Cold air dry | - | 0.25min |
| OSP bath process | Disclosed in Table 4 | Disclosed in Table 4 |
| Cold air dry | - | 2 min |
| Hot air dry | - | 70 °C,2 min |

**Table 4 OSP bath process**

| **Example** | **Process Study** | **Process Step** | **Temperature (°C)** | **Duration (min)** |
|---|---|---|---|---|
| **1 (Comparative)** | Azole bath | Bath 1 | 40 °C | 10 |
| **2 (Comparative)** | Pyrazine bath | Bath 2 | 40 °C | 10 |
| **3 (Comparative)** | Reverse order of two steps OSP process | Bath 2 | 40 °C | 5 |
| | | RO water rise | 25 °C | 1 |
| | | Cold air dry | - | 0.25 |
| | | Bath 1 | 40 °C | 5 |
| **4** | Two steps OSP process of the invention | Bath 1 | 40 °C | 5 |
| | | RO water rise | 25 °C | 1 |
| | | Cold air dry | - | 0.25 |
| | | Bath 2 | 40 °C | 5 |

The test samples were then reflowed five times. Thermal reflow condition was, 255 °C for 5 seconds at peak temperature using MALCOM desktop reflow oven. Test samples before and after five times reflow were observed. Serious discoloration was found for test samples for Examples 1, 2 and 3. In contrast, Example 4 showed no discoloration after five reflow steps. The results showed that the two step OSP process of Example 4 formed a thermally stable OSP coating on the copper surface.

### Examples 5 and 6

The following three baths were prepared.

**Table 5 Bath 3**

| Chemicals | Amounts |
|---|---|
| Benzimidazole | 5 g/L |
| Acetic acid | adjust pH |
| Water | remains |

| | |
|---|---|
| pH of the Bath 3 was 6.8 -7.0. | |

**Table 6 Bath 4**

| Chemicals | Amounts |
|---|---|
| 2-(4-chlorobenzyl)-1H-bnzimidazole | 2 g/L |
| Acetic acid | adjust pH |
| Water | remains |

| | |
|---|---|
| pH of the Bath 4 was 3.5 - 3.8. | |

**Table 7 Bath 5**

| Chemicals | Amounts |
|---|---|
| 1H-imidazole[4,5-b]pyrazine | 0.5 g/L |
| Acetic acid /Ammonia | adjust pH |
| Ammonium chloride | 100 ppm |
| Water | remains |

| | |
|---|---|
| pH of the bath was 3.7 - 4.0. | |

The same process as disclosed in Table 3 was conducted, except that the OSP process disclosed in Table 8 was used instead of the OSP process disclosed in Table 4.

**Table 8 OSP bath process**

| **Example** | **Process Study** | **Process Step** | **Temperature (°C)** | **Duration (min)** |
|---|---|---|---|---|
| **5** | Two steps OSP process of the invention | Bath 3 | 40 °C | 5 |
| | | RO water rise | 25 °C | 1 |
| | | Cold air dry | - | 0.25 |
| | | Bath 5 | 40 °C | 5 |
| **6 (Comparative)** | Two steps OSP process but second bath comprise another azole compound | Bath 3 | 40 °C | 5 |
| | | RO water rise | 25 °C | 1 |
| | | Cold air dry | - | 0.25 |
| | | Bath 4 | 40 °C | 5 |

The same reflow step as of Example 1 was conducted. After reflowing five times, no discoloration was observed for test samples of Example 5 while apparent discoloration was observed for test samples of Example 6. The results showed that the two step OSP process of the invention had better thermal stability than the process of the two step OSP process but using two different azole compounds.

Wetting balance test was conducted to evaluate the solderability of a copper surface with an OSP film before and after reflowing five times. The test parameters are shown in Table 9 below:

**Table 9**

| | |
|---|---|
| Test time | 1ms |
| Immersion speed | 1 mm/s |
| Removal speed | 10 mm/s |
| Temperature setting | 255 °C |
| Solder | 2 mm SAC 305 |
| Flux | Alpha EF 8000 |

From the wetting balance test results shown in Table 10, OSP coatings of Example 5 showed much better solderability than those from Example 6 and some de-wetting was observed.

**Table 10**

| Examples | | T_{b} (sec) | T_{2/3 Fmax} (sec) | Fₘₐₓ (mN) | Solder Coverage |
|---|---|---|---|---|---|
| 5 | Before reflow | 0.13 | 0.51 | 2.18 | 100% |
| | 5 times reflow | 0.26 | 1.92 | 1.42 | 100% |
| 6 | Before reflow | 0.25 | 0.47 | 2.02 | 100% |
| | 5 times reflow | 0.17 | 2.02 | 1.33 | 80% |

### Examples 7-9

The performance of the two steps OSP process of the invention was compared with two commercial OSP products. Commercial bath 1 was a one step treatment while Commercial bath 2 was a two step treatment.

**Table 11**

| Examples | OSP bath | One step or two steps |
|---|---|---|
| 7 | The same bath used in Example 4 | 2 |
| 8 | Commercial bath 1 | 1 |
| 9 | Commercial bath 2 | 2 |

The following tests were conducted for test samples treated by the OSP baths of Examples 7 to 9.

### (1) Discoloration after thermal reflow

Thermal reflow test was conducted same as Example 1, except that the reflow cycles were changed to 5 cycles and 9 cycles, before and after thermal reflow were observed. After 5 cycles and 9 cycles of thermal reflow, samples of Example 7 showed good thermal stability, no discoloration was found while significant color changes were found for samples of Examples 8 and 9. The color of these samples turned to seriously dark yellow compared with the sample before thermal reflow.

### (2) Thickness of OSP films

Focused Ion Beam Microscopy (FIB) was used to measure the coating thickness and study the continuity coating of each sample from cross sections of the test samples before and after thermal reflow cycles. Table 11 shows the thickness of OSP film for each sample. The average thicknesses were calculated from 9 points measured randomly from FIB-SEM images.

**Table 12**

| **Samples** | | **Thickness (nm)** |
|---|---|---|
| Example 7 | Before reflow | 88 |
| | 5 times reflow | 81 |
| | 9 times reflow | 81 |
| Example 8 | Before reflow | 260 |
| | 5 times reflow | 184 |
| | 9 times reflow | 80 |
| Example 9 | Before reflow | 450 |
| | 5 times reflow | 344 |
| | 9 times reflow | 217 |

Referring to Table 12, the coatings for samples of Example 7 were relatively thinner than those of Examples 8 and 9. The average thickness of the samples of Example 7 was less than 100 nm while those of Examples 8 and 9 were over 200 nm. The OSP films of the samples of Example 7 were found to be continuous and conformal on the surface of all samples before and after 5 and 9 cycles of thermal reflow. In contrast, the OSP film of the samples of Examples 8 and 9 were also continuous but not conformal. After 5 and 9 cycles of thermal reflow, the thickness of these OSP films were significantly decreased and became non-continuous organic layers.

### (3) XPS analysis

X-ray photoelectron spectroscopy (XPS) was used to evaluate the change of elemental distribution in the coatings caused by thermal reflow. Table 13 shows the XPS results (atomic percentage) of the samples of Example 7 to 9. For all samples, 30 layers were etched. The ion energy used was 2000 eV and different sputtering times were set for different samples as different thickness observed from FIB in order to obtain the information from the surface to the inner copper layer for all samples. The sputtering times for the samples of Example 7, 8 and 9 were 30s, 120s and 60s respectively. For all samples, the first layer was removed due to the surface contamination.

**Table 13**

| | | **Example 7** | **Example 9** | **Example 8** |
|---|---|---|---|---|
| **Oxygen** | **Before reflow** | 2.5% | 0.6% | 1.0% |
| | **5 times** | 2.8% | 3.6% | 4.3% |
| | **9 times** | 2.7% | 5.8% | 4.3% |
| **Copper** | **Before reflow** | 15.1% | 2.3% | 2.7% |
| | **5 times** | 17.0% | 10.3% | 16.6% |
| | **9 times** | 18.4% | 10.7% | 17.9% |

From Table 13, coating of Example 7 showed 2.5% of oxygen and 15.1% of copper in the sample before reflow. Meanwhile, about 4.7% of chloride was found at the first few layers due to the addition of ammonium chloride in the formulation. Both the oxygen content and the copper content in the OSP coating of Example 7 were higher than the OSP coatings of Examples 8 and 9 (for samples before reflow). The oxygen may be brought by the formation of carbonyl in the film and the higher copper content indicates that the film formed on the copper surface is a more copper complex rather than a pure organic layer formed by self-assembly of the organic molecules.

For the OSP coating of Example 7, the change in the content of oxygen and copper were not significant after 5 and 9 cycles of thermal reflow. After 9 cycles of thermal reflow, only 2.7% of oxygen and 18.4% of copper were observed in the OSP layers. The results showed that the two step OSP coating of Example 7 had a good ability to block the oxygen penetration from the outside and the copper diffusion from the inside. For OSP coatings of Examples 8 and 9, it was found that there was very low oxygen and copper content for samples before reflow. The oxygen and copper content were less than 1% and less than 3% respectively. After thermal reflows, both oxygen and copper content at the surface were increased significantly for both samples. The increase in the oxygen and copper content was consistent with the analysis results in FIB shown in the previous section.

### (4) Ball shear test

In order to show whether or not the OSP coatings would influence the solder joint formation after the soldering, the ball shear tests were performed and the results were compared with coatings of Examples 8 and 9. The ball shear test parameters were shown in Table 14 below.

**Table 14**

| | |
|---|---|
| Test speed | 200µm/s |
| Test load | 30g |
| Ball diameter | 0.635 mm |
| Solder ball | SAC305 (96.5%Sn, 3%Ag, 0.5%Cu) |
| Flux | Alpha OM338 (ROL0) |
| Number of samples | 33 |
| Reflow profile | SAC profile with peak temperature 270 °C |

For the OSP coating of Example 7, normal shear force was recorded for all sample points, and no planar voids were observed from the cross-section view. Similar results were observed for OSP coating of Examples 8 and 9. The results indicated that the solder joint from the OSP coating of Example 7 was comparable with those of Examples 8 and 9 (Table 15).

**Table 15 Ball shear test results (Mean (g))**

| Samples | Before Thermal reflow | 5 times Thermal reflow | 9 times Thermal reflow |
|---|---|---|---|
| Example 7 | 1430 ± 164 | 1642 ± 167 | 1459 ± 150 |
| Example 9 | 1546 ± 152 | 1623 ± 215 | 1451 ± 230 |
| Example 8 | 1411 ± 267 | 1550 ± 154 | 1513 ± 141 |

### (5) Coating selectivity test

Test substrates were prepared with electroless nickel - immersion gold (ENIG) process (Ni thickness:5 µm; Au thickness: 0.05 µmm) as shown in Table 16, and then two steps OSP process same as Example 4 were conducted.

**Table 16**

| ENIG process | | |
|---|---|---|
| **Process Step** | **Temperature** | **Time** |
| RONACLEAN™ LP-200 + 5 % sulfuric acid | 40 °C | 5 min |
| RO water rinse | R. T. | 1.5 min |
| 100 g/L sodium persulfate + 20 mL/L sulfuric acid | R. T. | 2 min |
| RO water rinse | R. T. | 2 min |
| Pre-dip : 5% sulfuric acid | R. T. | 1 min |
| RONAMAX™ CATALYST CF | R. T. | 2 min |
| RO water rinse | R. T. | 1 min |
| Post-dip : 5% sulfuric acid | R. T. | 1 min |
| RO water rinse | R. T. | 1 min |
| DURAPOSIT™ SMT 88 Electroless Nickel | 85 °C | 22 min |
| RO water rinse | R. T. | 2 min |
| AUROLECTROLESS™ 520 Immersion Gold | 88 °C | 10 min |
| RO water rinse | R. T. | 2 min |
| Air Dry | - | 3 min |

Following the treatment, the sample appearance was recorded and compared with the corresponding as-received ENIG samples. Coating selectivity of the two step OSP process was good and no appearance change was found on the ENIG surface after the OSP process. Golden appearance was observed after the OSP process.

## Claims

1. A method for forming an organic film on a copper surface of an article, comprising the steps of:
(a) contacting the copper surface with a first solution comprising benzimidazole or derivatives thereof, and
(b) contacting the copper surface, after contacted with the first solution, with a second solution comprising a compound represented by the formula (I) 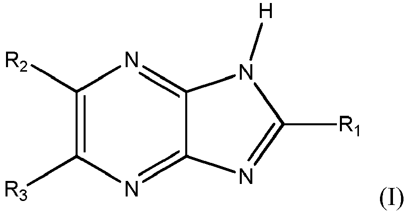
wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 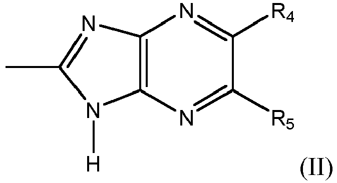 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

2. The method of claim 1, wherein the second solution comprises the compound represented by the formula (I) in amount of 0.1 g/L to 50 g/L.

3. The method of claim 1, wherein the first solution further comprises the compound represented by the formula (I).

4. The method of claim 1, wherein the second solution further comprises metal ions selected from Cu, Sn, Zn, Ag, Ni, Pd, Ba, Mg, Fe, Au, Pt, W, Bi, Sb, Mn and Pd.

5. The method of claim 1, wherein the second solution further comprises ammonium chloride.

6. The method of claim 1, wherein the article further comprises a gold surface and the organic film selectively deposit on copper surface with substantially no deposit on gold surface.

7. An organic film on a copper surface comprising (i) a first layer formed on the copper surface and comprising benzimidazole or derivatives thereof and (ii) a second layer formed on the first layer and comprising a compound represented by the formula (I) 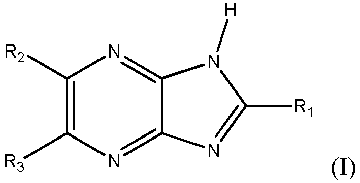 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 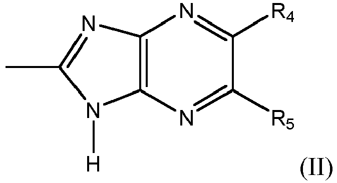 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

8. The organic film of claim 7, wherein the thickness of the film comprising the first layer and the second layer is from 10 to 500 nm.

9. A method for protecting a copper surface of an article from oxidation, comprising the steps of:
(a) preparing an article having copper surface,
(b)contacting the copper surface of the article with a first solution comprising benzimidazole or derivatives thereof to form a first organic film on the surface of copper,
(c) contacting the copper surface which has the first organic film with a second solution comprising a compound represented by the formula (I) 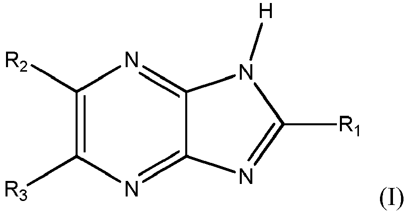 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 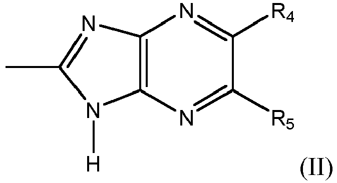 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms, and
(d) drying the copper surface to form an organic film on the surface.

10. The method of claim 9, in which the article further comprises a gold surface, wherein the organic film selectively deposit on copper surface with substantially no deposit on gold surface.

11. The method of claim 9, wherein the article is selected from printed circuit board, electronic components and decorative accessories.

## Patentansprüche

1. Ein Verfahren zum Bilden eines organischen Films auf einer Kupferoberfläche eines Artikels, das die folgenden Schritte beinhaltet:
(a) In-Kontakt-Bringen der Kupferoberfläche mit einer ersten Lösung, die Benzimidazol oder Derivate davon beinhaltet, und
(b) In-Kontakt-Bringen der Kupferoberfläche, nach dem In-Kontakt-Bringen mit der ersten Lösung, mit einer zweiten Lösung, die eine durch die Formel (I) dargestellte Verbindung beinhaltet, 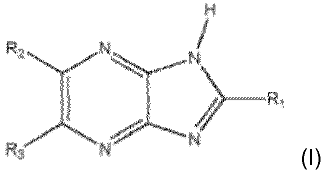
wobei R₁, R₂ und R₃ unabhängig Wasserstoff, substituiertes oder nichtsubstituiertes, lineares, verzweigtes oder cyclisches Alkyl, Halogenid, Nitro, Hydroxyl, Cyano, Carboxyl, Ester, Mercapto, Alkylthio, Thioester, Amino, Amid, Boryl oder Silyl sind; R₂ und R₃ mit all ihren Atomen zusammengenommen werden können, um einen fünfgliedrigen heterocyclischen Ring zu bilden, wobei der heterocyclische Ring zwei Stickstoffatome als die Heteroatome umfasst, und R₁ die folgende Struktur aufweisen kann: 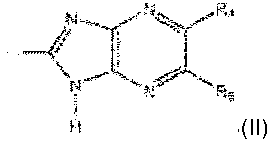 wobei R₄ und R₅ unabhängig Wasserstoff, Halogenid, Nitro, Hydroxyl, Cyano, substituiertes oder nichtsubstituiertes, lineares, verzweigtes oder cyclisches Hydrocarbyl, substituiertes oder nichtsubstituiertes, lineares oder verzweigtes Alkoxyl, Carboxyl, Ester, Mercapto, Alkylthio, Thioester, Amino, Amid, Boryl oder Silyl sind; R₄ und R₅ mit all ihren Atomen zusammengenommen werden können, um einen fünfgliedrigen heterocyclischen Ring zu bilden, wobei der heterocyclische Ring zwei Stickstoffatome als die Heteroatome umfasst.

2. Verfahren gemäß Anspruch 1, wobei die zweite Lösung die durch die Formel (I) dargestellte Verbindung in einer Menge von 0,1 g/l bis 50 g/l beinhaltet.

3. Verfahren gemäß Anspruch 1, wobei die erste Lösung ferner die durch die Formel (I) dargestellte Verbindung beinhaltet.

4. Verfahren gemäß Anspruch 1, wobei die zweite Lösung ferner aus Cu, Sn, Zn, Ag, Ni, Pd, Ba, Mg, Fe, Au, Pt, W, Bi, Sb, Mn und Pd ausgewählte Metallionen beinhaltet.

5. Verfahren gemäß Anspruch 1, wobei die zweite Lösung ferner Ammoniumchlorid beinhaltet.

6. Verfahren gemäß Anspruch 1, wobei der Artikel ferner eine Goldoberfläche und den selektiv auf der Kupferoberfläche abgelagerten organischen Film mit im Wesentlichen keiner Ablagerung auf der Goldoberfläche beinhaltet.

7. Ein organischer Film auf einer Kupferoberfläche, beinhaltend (i) eine erste Schicht, die auf der Kupferoberfläche gebildet ist und Benzimidazol oder Derivate davon beinhaltet, und (ii) eine zweite Schicht, die auf der ersten Schicht gebildet ist und eine durch die Formel (I) dargestellte Verbindung beinhaltet, 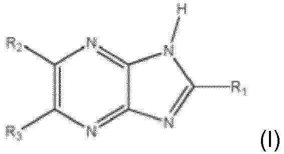 wobei R₁, R₂ und R₃ unabhängig Wasserstoff, substituiertes oder nichtsubstituiertes, lineares, verzweigtes oder cyclisches Alkyl, Halogenid, Nitro, Hydroxyl, Cyano, Carboxyl, Ester, Mercapto, Alkylthio, Thioester, Amino, Amid, Boryl oder Silyl sind; R₂ und R₃ mit all ihren Atomen zusammengenommen werden können, um einen fünfgliedrigen heterocyclischen Ring zu bilden, wobei der heterocyclische Ring zwei Stickstoffatome als die Heteroatome umfasst, und R₁ die folgende Struktur aufweisen kann: 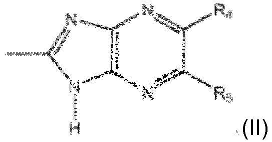 wobei R₄ und R₅ unabhängig Wasserstoff, Halogenid, Nitro, Hydroxyl, Cyano, substituiertes oder nichtsubstituiertes, lineares, verzweigtes oder cyclisches Hydrocarbyl, substituiertes oder nichtsubstituiertes, lineares oder verzweigtes Alkoxyl, Carboxyl, Ester, Mercapto, Alkylthio, Thioester, Amino, Amid, Boryl oder Silyl sind; R₄ und R₅ mit all ihren Atomen zusammengenommen werden können, um einen fünfgliedrigen heterocyclischen Ring zu bilden, wobei der heterocyclische Ring zwei Stickstoffatome als die Heteroatome umfasst.

8. Organischer Film gemäß Anspruch 7, wobei die Dicke des Films, der die erste Schicht und die zweite Schicht beinhaltet, 10 bis 500 nm beträgt.

9. Ein Verfahren zum Schützen einer Kupferoberfläche eines Artikels vor Oxidation, beinhaltend die folgenden Schritte:
(a) Herstellen eines Artikels, der eine Kupferoberfläche aufweist,
(b) In-Kontakt-Bringen der Kupferoberfläche des Artikels mit einer ersten Lösung, die Benzimidazol oder Derivate davon beinhaltet, um einen ersten organischen Film auf der Oberfläche aus Kupfer zu bilden,
(c) In-Kontakt-Bringen der Kupferoberfläche, die den ersten organischen Film aufweist, mit einer zweiten Lösung, die eine durch die Formel (I) dargestellte Verbindung beinhaltet, 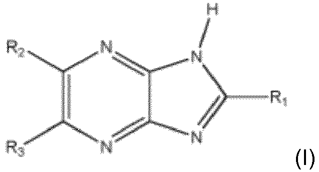 wobei R₁, R₂ und R₃ unabhängig Wasserstoff, substituiertes oder nichtsubstituiertes, lineares, verzweigtes oder cyclisches Alkyl, Halogenid, Nitro, Hydroxyl, Cyano, Carboxyl, Ester, Mercapto, Alkylthio, Thioester, Amino, Amid, Boryl oder Silyl sind; R₂ und R₃ mit all ihren Atomen zusammengenommen werden können, um einen fünfgliedrigen heterocyclischen Ring zu bilden, wobei der heterocyclische Ring zwei Stickstoffatome als die Heteroatome umfasst, und R₁ die folgende Struktur aufweisen kann: 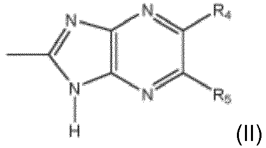 wobei R₄ und R₅ unabhängig Wasserstoff, Halogenid, Nitro, Hydroxyl, Cyano, substituiertes oder nichtsubstituiertes, lineares, verzweigtes oder cyclisches Hydrocarbyl, substituiertes oder nichtsubstituiertes, lineares oder verzweigtes Alkoxyl, Carboxyl, Ester, Mercapto, Alkylthio, Thioester, Amino, Amid, Boryl oder Silyl sind; R₄ und R₅ mit all ihren Atomen zusammengenommen werden können, um einen fünfgliedrigen heterocyclischen Ring zu bilden, wobei der heterocyclische Ring zwei Stickstoffatome als die Heteroatome umfasst, und
(d) Trocknen der Kupferoberfläche, um einen organischen Film auf der Oberfläche zu bilden.

10. Verfahren gemäß Anspruch 9, wobei der Artikel ferner eine Goldoberfläche beinhaltet, wobei der organische Film selektiv auf der Kupferoberfläche abgelagert wird, mit im Wesentlichen keiner Ablagerung auf der Goldoberfläche.

11. Verfahren gemäß Anspruch 9, wobei der Artikel aus einer Leiterplatte, elektronischen Komponenten und dekorativem Zubehör ausgewählt ist.

## Revendications

1. Un procédé pour la formation d'un film organique sur une surface en cuivre d'un article, comprenant les étapes consistant :
(a) à mettre la surface en cuivre en contact avec une première solution comprenant du benzimidazole ou des dérivés de celui-ci, et
(b) à mettre la surface en cuivre, après sa mise en contact avec la première solution, en contact avec une deuxième solution comprenant un composé représenté par la formule (I) 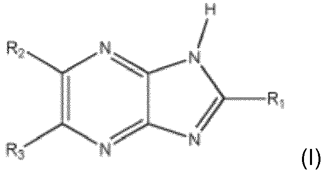
où R₁, R₂ et R₃ sont indépendamment un hydrogène, alkyle linéaire, ramifié ou cyclique, substitué ou non substitué, halogénure, nitro, hydroxyle, cyano, carboxyle, ester, mercapto, alkylthio, thioester, amino, amide, boryle ou silyle ; R₂ et R₃ peuvent être pris conjointement avec l'ensemble de leurs atomes pour former un noyau hétérocyclique à cinq chaînons où le noyau hétérocyclique inclut deux atomes d'azote comme hétéroatomes, et R₁ peut avoir la structure suivante : 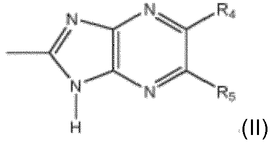 où R₄ et R₅ sont indépendamment un hydrogène, halogénure, nitro, hydroxyle, cyano, hydrocarbyle linéaire, ramifié ou cyclique, substitué ou non substitué, alcoxyle linéaire ou ramifié, substitué ou non substitué, carboxyle, ester, mercapto, alkylthio, thioester, amino, amide, boryle ou silyle ; R₄ et R₅ peuvent être pris conjointement avec l'ensemble de leurs atomes pour former un noyau hétérocyclique à cinq chaînons où le noyau hétérocyclique inclut deux atomes d'azote comme hétéroatomes.

2. Le procédé de la revendication 1, où la deuxième solution comprend le composé représenté par la formule (I) dans une quantité de 0,1g/L à 50 g/L.

3. Le procédé de la revendication 1, où la première solution comprend en sus le composé représenté par la formule (I).

4. Le procédé de la revendication 1, où la deuxième solution comprend en sus des ions métalliques sélectionnés parmi Cu, Sn, Zn, Ag, Ni, Pd, Ba, Mg, Fe, Au, Pt, W, Bi, Sb, Mn et Pd.

5. Le procédé de la revendication 1, où la deuxième solution comprend en sus du chlorure d'ammonium.

6. Le procédé de la revendication 1, où l'article comprend en sus une surface en or et le film organique se dépose de manière sélective sur la surface en cuivre sans substantiellement aucun dépôt sur la surface en or.

7. Un film organique sur une surface en cuivre comprenant (i) une première couche formée sur la surface en cuivre et comprenant du benzimidazole ou des dérivés de celui-ci et (ii) une deuxième couche formée sur la première couche et comprenant un composé représenté par la formule (I) 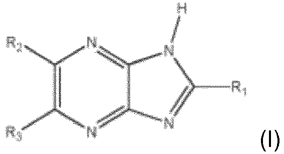 où R₁, R₂ et R₃ sont indépendamment un hydrogène, alkyle linéaire, ramifié ou cyclique, substitué ou non substitué, halogénure, nitro, hydroxyle, cyano, carboxyle, ester, mercapto, alkylthio, thioester, amino, amide, boryle ou silyle ; R₂ et R₃ peuvent être pris conjointement avec l'ensemble de leurs atomes pour former un noyau hétérocyclique à cinq chaînons où le noyau hétérocyclique inclut deux atomes d'azote comme hétéroatomes, et R₁ peut avoir la structure suivante : 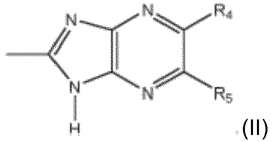 où R₄ et R₅ sont indépendamment un hydrogène, halogénure, nitro, hydroxyle, cyano, hydrocarbyle linéaire, ramifié ou cyclique, substitué ou non substitué, alcoxyle linéaire ou ramifié, substitué ou non substitué, carboxyle, ester, mercapto, alkylthio, thioester, amino, amide, boryle ou silyle ; R₄ et R₅ peuvent être pris conjointement avec l'ensemble de leurs atomes pour former un noyau hétérocyclique à cinq chaînons où le noyau hétérocyclique inclut deux atomes d'azote comme hétéroatomes.

8. Le film organique de la revendication 7, où l'épaisseur du film comprenant la première couche et la deuxième couche va de 10 à 500 nm.

9. Un procédé pour la protection d'une surface en cuivre d'un article contre l'oxydation, comprenant les étapes consistant :
(a) à préparer un article présentant une surface en cuivre,
(b) à mettre la surface en cuivre de l'article en contact avec une première solution comprenant du benzimidazole ou des dérivés de celui-ci afin de former un premier film organique sur la surface en cuivre,
(c) à mettre la surface en cuivre qui présente le premier film organique en contact avec une deuxième solution comprenant un composé représenté par la formule (I) 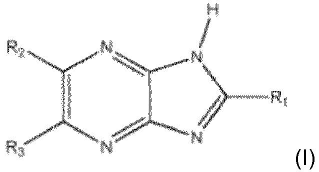 où R₁, R₂ et R₃ sont indépendamment un hydrogène, alkyle linéaire, ramifié ou cyclique, substitué ou non substitué, halogénure, nitro, hydroxyle, cyano, carboxyle, ester, mercapto, alkylthio, thioester, amino, amide, boryle ou silyle ; R₂ et R₃ peuvent être pris conjointement avec l'ensemble de leurs atomes pour former un noyau hétérocyclique à cinq chaînons où le noyau hétérocyclique inclut deux atomes d'azote comme hétéroatomes, et R₁ peut avoir la structure suivante : 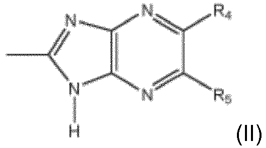 où R₄ et R₅ sont indépendamment un hydrogène, halogénure, nitro, hydroxyle, cyano, hydrocarbyle linéaire, ramifié ou cyclique, substitué ou non substitué, alcoxyle linéaire ou ramifié, substitué ou non substitué, carboxyle, ester, mercapto, alkylthio, thioester, amino, amide, boryle ou silyle ; R₄ et R₅ peuvent être pris conjointement avec l'ensemble de leurs atomes pour former un noyau hétérocyclique à cinq chaînons où le noyau hétérocyclique inclut deux atomes d'azote comme hétéroatomes, et
(d) à sécher la surface en cuivre afin de former un film organique sur la surface.

10. Le procédé de la revendication 9, dans lequel l'article comprend en sus une surface en or, où le film organique se dépose de manière sélective sur la surface en cuivre sans substantiellement aucun dépôt sur la surface en or.

11. Le procédé de la revendication 9, où l'article est sélectionné parmi une carte de circuit imprimé, des composants électroniques et des accessoires de décoration.
